# EUROPEAN PATENT APPLICATION

(11) **EP 4 270 454 A2**
(43) Date of publication of application: **01.11.2023**
(21) Application number: 23168313.7
(22) Date of filing: 17.04.2023
(51) Int. Cl.: H01L 21/56, H01L 23/24, H01L 23/31, H01L 21/54, H01L 23/16

(54) **POWER SEMICONDUCTOR MODULE COMPRISING A FIRST AND A SECOND COMPARTMENT AND METHOD FOR FABRICATING THE SAME**

(30) Priority: 28.04.2022 EP 22170459; 05.05.2022 US 202217737486
(71) Applicant: Infineon Technologies AG, 85579 Neubiberg (DE)
(72) Inventor: HARTUNG, Hans, 59581 Warstein (DE); GOLDAMMER, Martin, 59494 Soest (DE); EHLERS, Carsten, 41066 Mönchengladbach (DE); ENGELKEMEIER, Katja, 33154 Salzkotten (DE); BOENIG, Guido, 59581 Warstein (DE)
(74) Representative: Lambsdorff & Lange Patentanwälte Partnerschaft mbB

(57) **Abstract**

A power semiconductor module comprises: a power semiconductor die arranged on a power substrate, a housing enclosing the power semiconductor die and the power substrate, wherein an interior volume formed by the housing is divided by interior walls into at least a first compartment and a second compartment, wherein the power semiconductor die is arranged within the first compartment, a first encapsulation material encapsulating the power semiconductor die and at least partially filling the first compartment, and a second encapsulation material different from the first encapsulation material, the second encapsulation material encapsulating the first encapsulation material and at least partially filling the second compartment, wherein the first encapsulation material is arranged within the first compartment but not within the second compartment.

## Description

### TECHNICAL FIELD

This disclosure relates in general to a power semiconductor module comprising a first and a second compartment, as well as to a method for fabricating such a power semiconductor module.

### BACKGROUND

Power semiconductor modules may comprise an encapsulation material configured to encapsulate and protect sensitive components like power semiconductor dies and electrical connectors (e.g. bond wires, ribbons or contact clips). Technological progress has led to the development of power semiconductor modules for voltage classes of e.g. 6.5kV and higher, as well as to an increased power density within the power semiconductor modules. This also causes increased temperature peaks during operation within the power semiconductor modules. Common encapsulation materials may not be configured to handle such extreme temperatures and therefore it may be necessary to use high performance encapsulation materials. However, such high performance encapsulation materials may be comparatively costly and may significantly increase the overall costs of the power semiconductor module. Improved methods for fabricating a power semiconductor module as well as improved power semiconductor modules may help in solving these and other problems.

### SUMMARY

Various aspects pertain to a power semiconductor module, comprising: a power semiconductor die arranged on a power substrate, a housing enclosing the power semiconductor die and the power substrate, wherein an interior volume formed by the housing is divided by interior walls into at least a first compartment and a second compartment, wherein the power semiconductor die is arranged within the first compartment, a first encapsulation material encapsulating the power semiconductor die and at least partially filling the first compartment, and a second encapsulation material different from the first encapsulation material, the second encapsulation material encapsulating the first encapsulation material and at least partially filling the second compartment, wherein the first encapsulation material is arranged within the first compartment but not within the second compartment.

Various aspects pertain to a method for fabricating a power semiconductor module, the method comprising: arranging a power semiconductor die on a power substrate, enclosing the power semiconductor die and the power substrate with a housing, wherein an interior volume formed by the housing is divided by interior walls into at least a first compartment and a second compartment, wherein the power semiconductor die is arranged within the first compartment, encapsulating the power semiconductor die with a first encapsulation material such that the first encapsulation material at least partially fills the first compartment, and encapsulating the first encapsulation material with a second encapsulation material different from the first encapsulation material, such that the second encapsulation material at least partially fills the second compartment, wherein the first encapsulation material is arranged within the first compartment but not within the second compartment.

### BRIEF DESCRIPTION OF THE DRAWINGS

The accompanying drawings illustrate examples and together with the description serve to explain principles of the disclosure. Other examples and many of the intended advantages of the disclosure will be readily appreciated in view of the following detailed description. The elements of the drawings are not necessarily to scale relative to each other. Identical reference numerals designate corresponding similar parts.
Figures 1A to 1F show a power semiconductor module comprising a first and a second compartment in various stages of fabrication, according to an exemplary method for fabricating power semiconductor modules. Figs. 1A-1D and 1F show a sectional view and Fig. 1E shows a plan view.
Figure 2 shows plan view of a further power semiconductor module comprising a first and a second compartment.
Figure 3 shows a sectional view of a further power semiconductor module which also comprises an electrical connector and external contacts.
Figure 4 shows a sectional view of a further power semiconductor module which also comprises a three-dimensional grid structure that is immersed within a first encapsulation material within the first compartment.
Figure 5 a flow chart of an exemplary method for fabricating power semiconductor modules.
Figures 6A to 6F each show a sectional view of a further power semiconductor module comprising a first and a second encapsulation material in various stages of fabrication, according to a further exemplary method for fabricating power semiconductor modules.
Figures 7A and 7B show a process of depositing a precursor of an encapsulation material on a semiconductor die (Fig. 7A) and a process of curing the precursor in order to fabricate the encapsulation material (Fig. 7B).
Figure 8 shows a process of depositing a liquid precursor of an encapsulation material, wherein a plurality of lines of the liquid precursor are dispensed on top of each other.
Figure 9 shows a process of depositing a precursor of an encapsulation material, wherein a temporary frame is used to keep the precursor in place.
Figure 10 is a flow chart of a further exemplary method for fabricating power semiconductor modules.

### DETAILED DESCRIPTION

In the following detailed description, directional terminology, such as "top", "bottom", "left", "right", "upper", "lower" etc., is used with reference to the orientation of the Figure(s) being described. Because components of the disclosure can be positioned in a number of different orientations, the directional terminology is used for purposes of illustration only. It is to be understood that other examples may be utilized and structural or logical changes may be made without departing from the scope of the present invention.

In addition, to the extent that the terms "include", "have", "with" or other variants thereof are used in either the detailed description or the claims, such terms are intended to be inclusive in a manner similar to the term "comprise". The terms "coupled" and "connected", along with derivatives thereof may be used. It should be understood that these terms may be used to indicate that two elements cooperate or interact with each other regardless whether they are in direct physical or electrical contact, or they are not in direct contact with each other. Also, the term "exemplary" is merely meant as an example, rather than the best or optimal.

An efficient method for fabricating power semiconductor modules as well as efficient power semiconductor modules may for example reduce material consumption, ohmic losses, chemical waste etc. and may thus enable energy and/or resource savings. Improved methods for fabricating power semiconductor modules, as well as improved power semiconductor modules, as specified in this description, may thus at least indirectly contribute to green technology solutions, i.e. climate-friendly solutions providing a mitigation of energy and/or resource use.

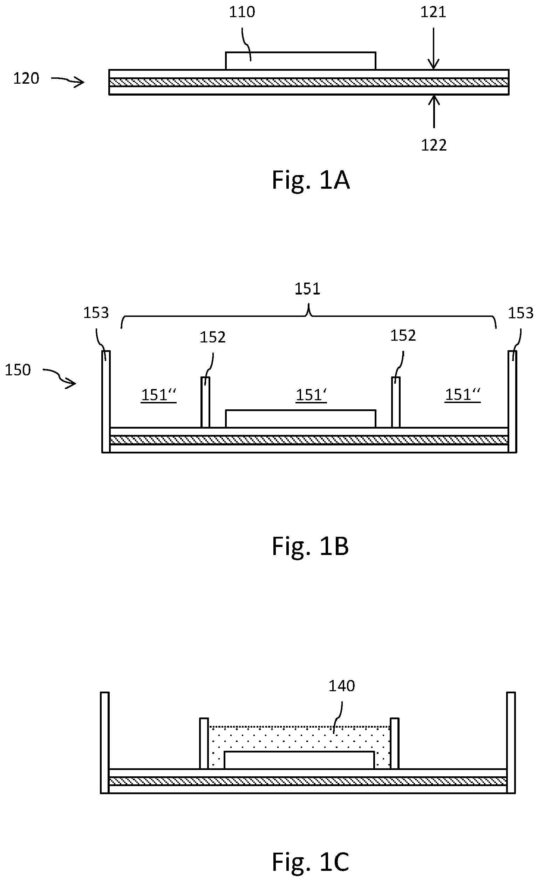

Figures 1A to 1F show a power semiconductor module 100 in various stages of fabrication, according to an exemplary method for fabricating a power semiconductor module.

As shown in Figure 1A, the method comprises a process of arranging a power semiconductor die 110 on a power substrate 120.

The power semiconductor die 110 may for example be a MOSFET, an IGBT, a diode, etc. The power semiconductor die 110 may comprise a first electrode arranged on a lower side, wherein the lower side faces the power substrate 120, and a second electrode arranged on an upper side, wherein the upper side faces away from the power substrate 120. The first and second electrodes may for example be power electrodes of the power semiconductor die 110 (e.g. source, drain, emitter or collector electrodes). The power semiconductor die 110 may comprise or consist of any suitable semiconductor material, for example Si, SiC, SiGe, GaAs or GaN.

Arranging the power semiconductor die 110 on the power substrate 120 may e.g. comprise soldering, sintering or gluing the power semiconductor die 110 onto the power substrate 120. In the case that the power semiconductor die 110 comprises a first electrode on the lower side, this may also comprise electrically coupling the first electrode to the power substrate 120.

According to an example, more than one power semiconductor die 110 is arranged on the power substrate 120. The more than one power semiconductor dies 110 may be of the same type or the more than one power semiconductor dies 110 may be different types of dies.

The power substrate 120 may for example be a substrate of the type DCB (direct copper bonded), DAB (direct aluminum bonded), AMB (active metal brazed), PCB (printed circuit board), etc. The power substrate 120 may comprise two electrically conductive layers separated from each other by an electrically isolating layer.

The power substrate 120 may comprise a first side 121 and an opposite second side 122. The power semiconductor die(s) 110 may for example be arranged on the first side 121. The second side 122 may for example be arranged on a baseplate (not shown in Figs. 1A-1F). According to another example, no baseplate is arranged on the second side 122.

According to an example, the power semiconductor die 110 is electrically connected to the power substrate 120 using an electrical connector (not shown in Figs. 1A-1F). This may in particular comprise electrically connecting a second electrode arranged on the upper side of the power semiconductor die 110 to the power substrate 120 via the electrical connector.

According to an example, the power semiconductor module 100 comprises more than one power semiconductor die 110 and at least one electrical connector is used to electrically couple the power semiconductor dies 110 to each other.

Electrically connecting the power semiconductor die 110 to the power substrate 120 via the electrical connector may comprise soldering, sintering or gluing the electrical connector to at least one electrode, e.g. a power electrode, of the power semiconductor die 110. The electrical connector may be any suitable type of connector, e.g. a bond wire, a ribbon or a contact clip. The electrical connector may for example comprise or consist of Al or Cu. The power semiconductor module 100 may also comprise more than one electrical connector. The more than one electrical connectors may be of the same type or the more than one electrical connectors may be different types of connectors, e.g. a bond wire and a contact clip.

As shown in Figure 1B, the power semiconductor die 110 and the power substrate 120 are enclosed with a housing 150. The housing 150 may comprise interior walls 152 and exterior walls 153. The exterior walls 153 of the housing 150 may define an interior volume 151 of the power semiconductor module 100, wherein the power semiconductor die 110 is arranged within the interior volume 151.

The housing 150 may for example comprise one or more frames. The frame (s) may comprise or consist of any suitable material, e.g. a cast material, a plastic, a metal like Al, etc.

The interior walls 152 are configured to separate the interior volume 151 into at least a first compartment 151' and a second compartment 151''. The power semiconductor module 100 may comprise a single first compartment 151' or more than one first compartment 151'. Additionally or alternatively, the power semiconductor module 100 may comprise a single second compartment 151'' or more than one second compartment 151''.

According to an example, the power semiconductor die 110 is arranged within the first compartment 151' and not within the second compartment 151". In the case that the power semiconductor module 100 comprises more than one power semiconductor die 110, several or all of the power semiconductor dies 110 may be arranged within a common first compartment 151'. Alternatively, the power semiconductor dies 110 may be arranged in several first compartments 151'.

The exterior walls of the housing 150 may be arranged around or at least partially around lateral sides of the power substrate 120, wherein the lateral sides connect the first and second sides 121, 122 of the power substrate 120. The power semiconductor module 100 may comprise external contacts (in particular external power contacts) which may be exposed from the housing 150. The external contacts may for example extend out of the housing 150 at the lateral sides of the power substrate 120 or close to the lateral sides.

The housing 150 may for example comprise or consist of one or more frames. For example, the interior walls 152 may be provided by a first frame and the exterior walls 153 may be provided by a second frame. Alternatively, the interior walls 152 and the exterior walls 153 may be part of the same frame. The housing 150 may be joined to the power substrate 120 or the housing 150 may be joined to a baseplate, wherein the power substrate 120 is arranged on the baseplate. Joining the housing 150 to the power substrate 120 or to the baseplate may for example be done by clipping, screwing, clamping or gluing.

The power semiconductor module 100 may be configured such that a tight seal, in particular a water-tight seal, is provided at the interface between the power substrate 120 and the housing 150. This seal may only need to be temporarily water-tight until a more permanent seal is provided by a second encapsulation material as described further below.

As shown in Figure 1C, the power semiconductor die 110 is covered with a first encapsulation material 140. This comprises at least partially filling the first compartment 151' with the first encapsulation material 140 or with a precursor of the first encapsulation material 140. According to an example, the first compartment 151' may be completely filled with the first encapsulation material 140.

According to an example, the first encapsulation material 140 encapsulates the power semiconductor die 110 on all sides except for the side that is covered by the power substrate 120.

According to an example, the first encapsulation material 140 encapsulates components of the power semiconductor module 100 that heat up to particularly high temperatures during operation (e.g. the power semiconductor die 110, connectors coupled to power electrodes of the power semiconductor die 110, etc.). The first encapsulation material 140 may be a dielectric material that electrically isolates these components from one another and from other potentials, such as a module baseplate. For example, the first encapsulation material 140 may have a dielectric strength of at least 16kV/mm and/or a specific resistance of at least 2 * 10¹⁵ Ω·cm or at least 2.5 * 10¹⁵ Ω·cm.

The first encapsulation material 140 may for example comprise or consist of a material which exhibits particularly high temperature stability. For example, the first encapsulation material 140 may exhibit less than 2% weight loss at 300°C. The first encapsulation material 140 may for example comprise or consist of a mold compound, in particular an inorganic mold compound. The first encapsulation material 140 may comprise or consist of a silicone resin. According to another example, The first encapsulation material 140 is introduced into the semiconductor module 100 as a liquid and remains as a liquid thereafter.

This liquid property of the first encapsulation material 140 differs from a from a curable potting compound, such as a dielectric gel, which may be heated to a liquid or gelatinous state during the initial encapsulation process and subsequently cured into a hardened or quasi-hardened state, e.g., by cooling, drying, exposure to an external agent or any combination thereof. In this context, a liquid may encompass a material with a dynamic viscosity of between 0.5×10⁻³ Pa·s (Pascals per second) and 50×10⁻³ Pa·s across the operational temperatures of the power semiconductor module 100.

The first encapsulation material 140 may be introduced into the power semiconductor module 100 as a liquid at room temperature (e.g. between about 20°-25°C). The first encapsulation material 140 may be a stable liquid, meaning that the first encapsulation material 140 does not decompose or otherwise chemically react with the components of the power semiconductor module 100, e.g., the power semiconductor die 110 and/or metal elements. The first encapsulation material 140 can retain the property of a stable liquid across all operational temperatures of the power semiconductor module 100. The operational temperatures of the power semiconductor module 100 can vary by application. The operational temperatures can be as low as -25°C, -40°C, -50°C, -55°C or lower and can be as high as 150°C, 200°C, 250°C, 300°C or higher. In one example, the operational temperatures of the power semiconductor module 100 are between -40°C and 200°C. Examples of a first encapsulation material 140 that satisfy the liquidity and stability requirements include oils such as silicon-based oils and petroleum-based oils such as transformer oil. The first encapsulation material 140 can also comprise synthetic materials such as Perfluoroalkyl and Polyfluoroalkyl based materials.

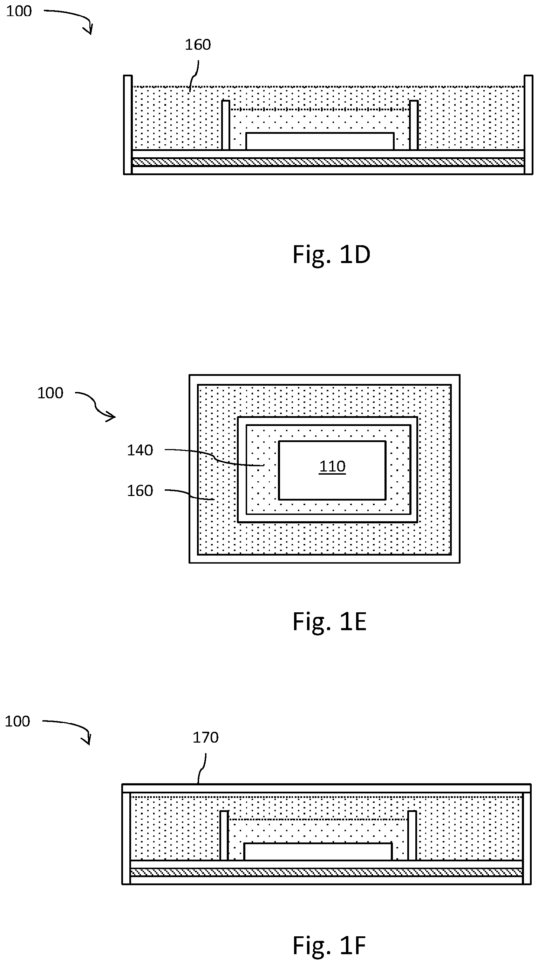

As shown in Figure 1D, a second encapsulation material 160 different from the first encapsulation material 140 is arranged on the first encapsulation material 140, encapsulating the first encapsulation material 140. The first and second encapsulation materials 140, 160 at least partially fill the interior volume 151 formed by the housing 150. The first and second encapsulation materials 140, 160 may also completely fill the interior volume 151.

According to an example, the first encapsulation material 140 fills the first compartment 151' only partially and the remainder of the first compartment 151' is filled by the second encapsulation material 160 (compare Fig. 1D). A volume of the second encapsulation material 160 may for example be 1.5 times as large, twice as large, three times as large, four times as large, or even larger than a volume of the first encapsulation material 140.

The first encapsulation material 140 may for example exhibit a higher thermostability than the second encapsulation material 160. This may mean that the first encapsulation material 140 is more resistant to irreversible changes in its chemical and/or physical structure at high temperatures than the second encapsulation material 160. The first encapsulation material 140 may for example exhibit less weight loss and/or less shrinkage at elevated temperatures than the second encapsulation material 160.

The second encapsulation material 160 may for example comprise or consist of a suitable organic material. The second encapsulation material 160 may for example comprise or consist of a potting material, a polymer, a silicone gel, epoxy resin, acrylate, etc.

The second encapsulation material 160 may e.g. be deposited on parts of the power semiconductor module 100 which during operation do not heat up above a critical temperature, e.g. a critical temperature of about 150°C or 175°C or 200°C or more. The first encapsulation material 140 on the other hand may be deposited on those parts of the power semiconductor module 100 which during operation do heat up to a temperature above the critical temperature.

The second encapsulation material 160 may for example completely cover the first encapsulation material 140 or the second encapsulation material 160 may only partially cover the first encapsulation material 140. The second encapsulation material 160 may be arranged directly on at least a portion of the first side 121 of the power substrate 120.

In the case that the first encapsulation material 140 is a liquid, the power semiconductor module 100 may be configured such that the liquid first encapsulation material 140 is contained by an impermeable seal. An impermeable seal refers to an enclosure formed by surfaces from one or more structures that are impervious to the flow of liquid therethrough. The impermeable seal maintains the volume of liquid first encapsulation material 140 within the interior volume 151 throughout the useful life of the power semiconductor module 100. The impermeable seal may be arranged to completely contain the liquid first encapsulation material 140 so that the power semiconductor module 100 can be turned upside down and/or be rapidly accelerated or decelerated and/or be subject to thermal cycling without the liquid leaking out of the interior volume. The second encapsulation material 160 and the power substrate 120 may form part of the impermeable seal, as the material composition of these elements is impervious to liquid flow. Optionally, the impermeable seal may be substantially air-tight, meaning that no unwanted air pockets are present within the seal, e.g., from ambient atmosphere during the encapsulation process.

According to an example, arranging the second encapsulation material 160 on the first encapsulation material 140 comprises depositing, in particular dispensing, the second encapsulation material into the interior volume 151.

Figure 1E shows a plan view of the power semiconductor module 100. Note that the encapsulation materials 140 are shown as transparent in Fig. 1E.

According to an example, the first encapsulation material 140 comprises a dye such that a leak can easily be detected by visual inspection.

As shown in Figure 1F, fabricating the power semiconductor module 100 may optionally comprise arranging a lid 170 on the housing 150, wherein the lid 170 may be configured to close off the interior volume 151.

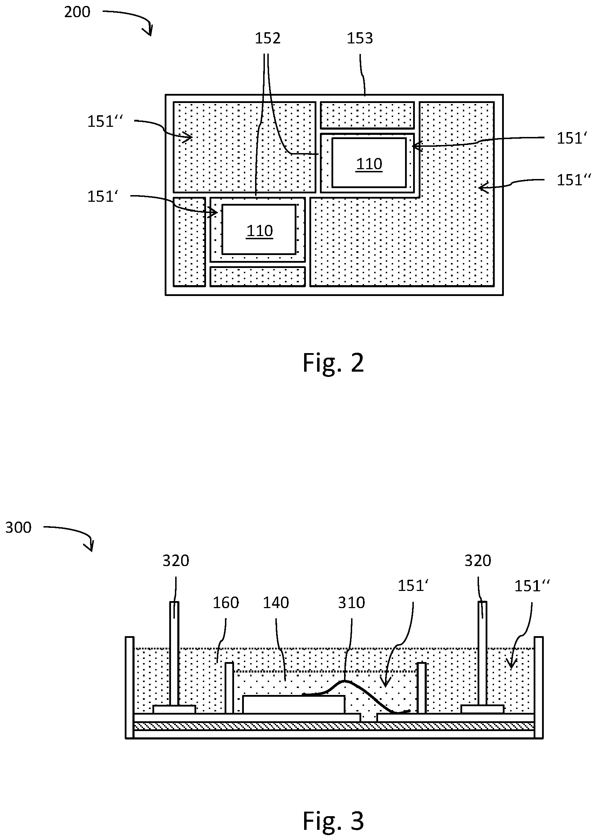

Figure 2 shows a plan view of a further power semiconductor module 200 which may be similar or identical to the power semiconductor module 100, except for the differences described in the following.

In particular, the interior volume 151 of the housing 150 of the power semiconductor module 200 is divided by the interior walls 152 into at least two first compartments 151' and at least two second compartments 151''.

According to the example shown in Fig. 2, at least some of the interior walls 152 are connected to the exterior walls 153. In particular, all interior and exterior walls 152, 153 may be connected such that the housing 150 is essentially a single piece.

Figure 3 shows a sectional view of a further power semiconductor module 300 which may be similar or identical to the power semiconductor module 100 or 200, except for the differences described in the following.

The power semiconductor module 300 comprises at least one electrical connector 310. The electrical connector 310 may for example comprise or consist of a bond wire, a ribbon or a contact clip. The electrical connector 310 may for example connect the power semiconductor die 110, e.g. a power terminal arranged on the upper side of the power semiconductor die 110, to the power substrate 120. The electrical connector 310 may be arranged within the first compartment 151' and may be encapsulated by the first encapsulation material 140.

The power semiconductor module 300 comprises at least one external contact 320 extending from the power substrate 120 to a location that is externally accessible outside of the interior volume 151. The external contact 320 may for example comprise or consist of a pin, in particular a press fit pin. The external contact 320 may be attached to a structured metallization layer of the power substrate 120, e.g. via solder, sinter, conductive glue, etc. The external contact 320 may be adapted to mate with a particular receptacle, e.g. a PCB. The external contact 320 may for example be a control or sensing contact, configured to transmit control or sensing signals between the power semiconductor module 300 and an external appliance.

As shown in Fig. 3, the at least one external contact 320 may be arranged in the second compartment 151'' such that the external contact 320 does not come into contact with the first encapsulation material 140. Therefore, there is no risk that a leak forms at the external contact 320 in the case that the first encapsulation material 140 is a liquid.

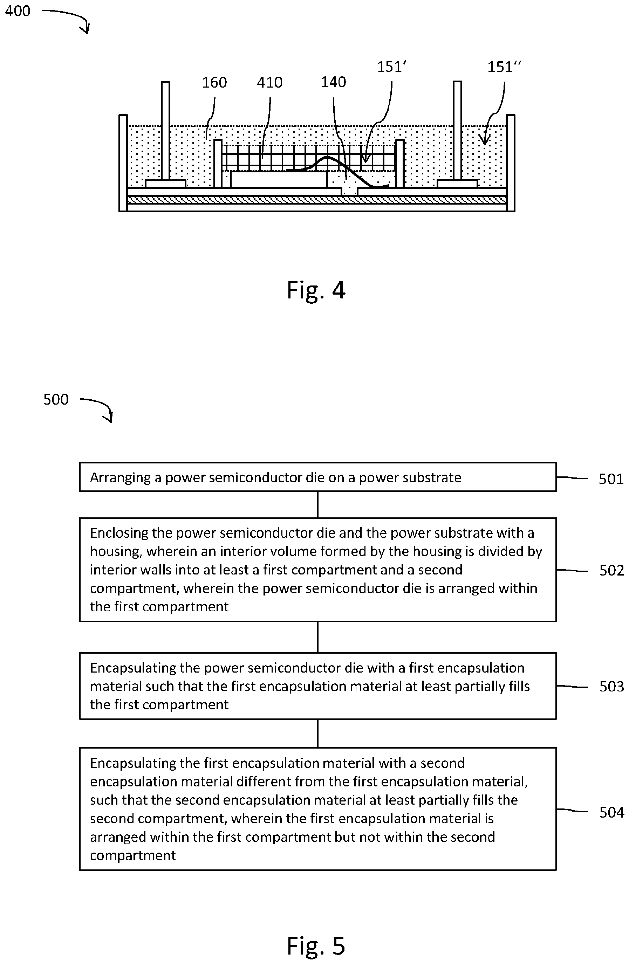

Figure 4 shows a sectional view of a further power semiconductor module 400 which may be similar or identical to the power semiconductor modules 100 to 300, except for the differences described in the following.

The power semiconductor module 400 comprises a three-dimensional grid structure 410 that is substantially rigid at room temperature and is immersed within the first encapsulation material 140.

Examples of such three-dimensional grid structures 410 include foams, sponges, technical filters, and three-dimensional textiles. The three-dimensional grid structure 410 may be formed from a material that is solid at room temperature. For example, the three-dimensional grid structure 410 can comprise a polymer or resin material. The three-dimensional grid structure 410 can be arranged in the first compartment 151' before dispensing the liquid first encapsulation material 140 into the first compartment 151'. The three-dimensional grid structure 410 may absorb the liquid first encapsulation material 140 and thereby evenly distribute the liquid first encapsulation material 140 throughout the first compartment 151'.

Additionally, the three-dimensional grid structure 410 may allow for easier formation of a sealant provided by the second encapsulation material 160 on top of the liquid first encapsulation material 140. One challenge in forming and curing a sealant material such as a potting compound on top of the liquid first encapsulation material 140 may be that the sealant material may fall into the liquid first encapsulation material 140. While it may be possible to obtain a leveling through the correct choice of specific masses of the materials and waiting time, the three-dimensional grid structure 410 can minimize material exchange between the sealant material and the liquid first encapsulation material 140 and hence allow easier formation of a seal.

Figure 5 is a flow chart of a method 500 for fabricating a power semiconductor module. The method 500 may for example be used to fabricate the power semiconductor modules 100 to 400.

The method 500 comprises at 601 a process of arranging a power semiconductor die on a power substrate; at 602 a process of enclosing the power semiconductor die and the power substrate with a housing, wherein an interior volume formed by the housing is divided by interior walls into at least a first compartment and a second compartment, wherein the power semiconductor die is arranged within the first compartment; at 603 a process of encapsulating the power semiconductor die with a first encapsulation material such that the first encapsulation material at least partially fills the first compartment; and at 604 a process of encapsulating the first encapsulation material with a second encapsulation material different from the first encapsulation material, such that the second encapsulation material at least partially fills the second compartment, wherein the first encapsulation material is arranged within the first compartment but not within the second compartment.

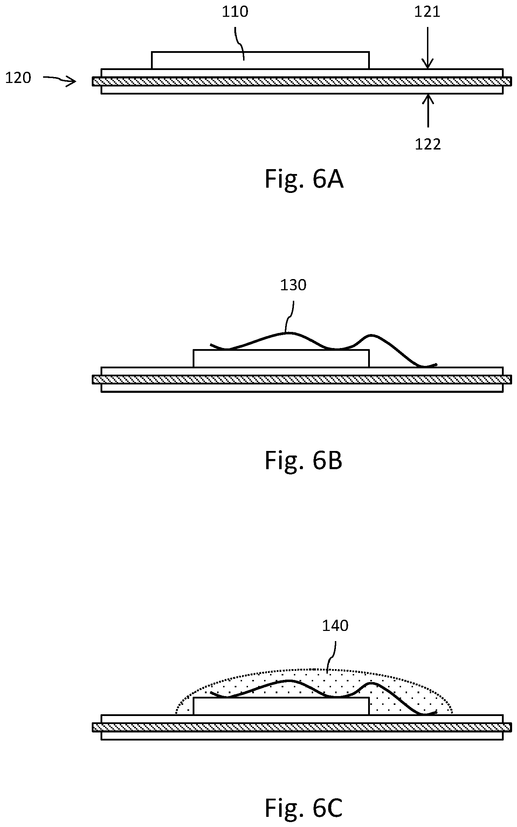

Figures 6A to 6F show a further power semiconductor module 600 in various stages of fabrication, according to an exemplary method for fabricating a power semiconductor module. The power semiconductor module 600 may be similar or identical to the power semiconductor module 100 to 400, except for the differences described in the following.

As shown in Figure 6A, the method comprises a process of arranging a power semiconductor die 110 on a power substrate 120.

As shown in Figure 6B, the power semiconductor die 110 is electrically connected to the power substrate 120 using an electrical connector 130. This may in particular comprise electrically connecting a second electrode arranged on the upper side of the power semiconductor die 110 to the power substrate 120 via the electrical connector 130.

According to an example, the power semiconductor module 600 comprises more than one power semiconductor die 110 and at least one electrical connector 130 is used to electrically couple the power semiconductor dies 110 to each other.

Electrically connecting the power semiconductor die 110 to the power substrate 120 via the electrical connector 130 may comprise soldering, sintering or gluing the electrical connector 130 to at least one electrode, e.g. a power electrode, of the power semiconductor die 110.

The electrical connector 130 may be any suitable type of connector, e.g. a bond wire, a ribbon or a contact clip. The electrical connector 130 may for example comprise or consist of Al or Cu. The power semiconductor module 600 may also comprise more than one electrical connector 130. The more than one electrical connectors 130 may be of the same type or the more than one electrical connectors 130 may be different types of connectors, e.g. a bond wire and a contact clip.

As shown in Figure 6C, at least selective portions of the power semiconductor die 110 and the electrical connector 130 are covered with a first encapsulation material 140.

According to an example, selective portions of the power semiconductor die 110 are covered with the first encapsulation material 140 while other portions of the power semiconductor die 110 are left exposed from the first encapsulation material 140. According to another example, the whole power semiconductor die 110 is covered with the first encapsulation material 140. According to an example, selective portions of the electrical connector 130 are covered with the first encapsulation material 140 while other portions of the electrical connector 130 are left exposed from the first encapsulation material 140. According to another example, the whole electrical connector 130 is covered with the first encapsulation material 140. Additionally or alternatively, the first encapsulation material 140 may be used to cover selective portions of the power substrate 120 while other portions of the power substrate 120 are left exposed from the first encapsulation material 140.

Selective portions of the power semiconductor die 110 that are covered with the first encapsulation material 140 may for example comprise power electrodes of the power semiconductor die 110 and/or generally any part of the power semiconductor die 110 which heats up to particularly high temperatures during operation of the power semiconductor module 600.

Selective portions of the electrical connector 130 that are covered with the first encapsulation material 140 may for example comprise portions that are close to a power electrode of the power semiconductor die 110 and/or portions that have a particularly high current density and/or portions that heat up to particularly high temperatures during operation of the power semiconductor module 600.

The first encapsulation material 140 may for example comprise or consist of a material which exhibits particularly high temperature stability. For example, the first encapsulation material 140 may exhibit less than 2% weight loss at 300°C. The first encapsulation material 140 may for example comprise or consist of a mold compound, in particular an inorganic mold compound. The first encapsulation material 140 may comprise or consist of a silicone resin.

According to an example, the first encapsulation material 140 comprises filler particles, for example filler particles selected from the group containing Al₂O₃, BN, AlN, Si₃N₄, diamond, or any other thermally conductive particles. The filler particles may for example account for 20% or more, 40% or more, 60% or more, or 80% or more of the total volume of the first encapsulation material 140.

According to an example, the power semiconductor die 110 and the electrical connector 130 (or at least the selective portions thereof) may be covered with the first encapsulation material 140 before the power substrate 120 is arranged on a baseplate. In this manner, the power semiconductor die 110 and the electrical connector 130 may be protected from environmental influences at an early stage of fabrication of the power semiconductor module 600. According to another example, the first encapsulation material 140 is applied after the power substrate 120 has been arranged on a baseplate.

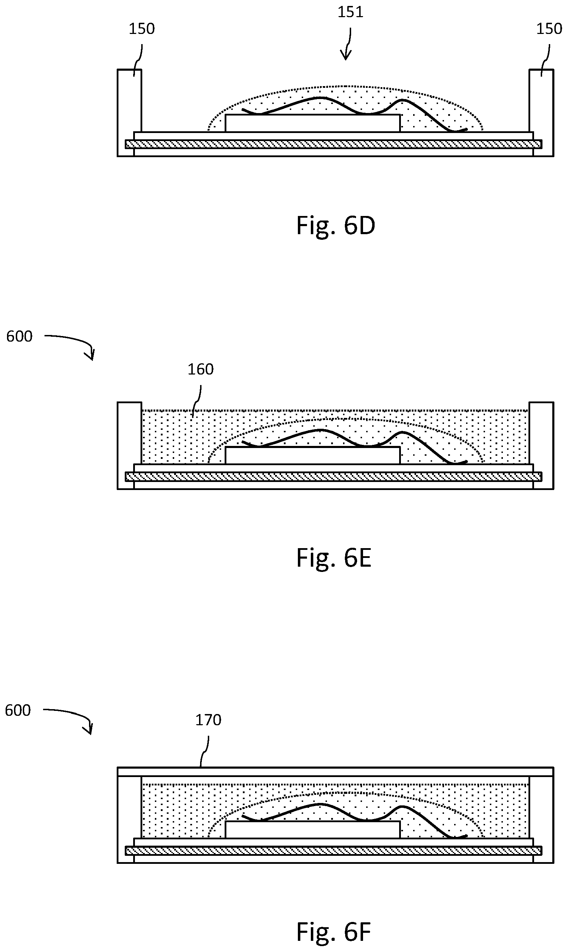

As shown in Figure 6D, the power semiconductor die 110 and the power substrate 120 are enclosed with a housing 150. The housing 150 may define an interior volume 151, wherein the power semiconductor die 110 and the first encapsulation material 140 are arranged within the interior volume 151.

The housing 150 may be arranged around or at least partially around lateral sides of the power substrate 120, wherein the lateral sides connect the first and second sides 121, 122 of the power substrate 120. The power semiconductor module 600 may comprise external contacts (in particular external power contacts) which may be exposed from the housing 150. The external contacts may for example extend out of the housing 150 at the lateral sides of the power substrate 120 or close to the lateral sides.

The housing 150 may for example comprise or consist of a frame, in particular a plastic frame. The housing 150 may be joined to the power substrate 120 or the housing 150 may be joined to a baseplate, wherein the power substrate 120 is arranged on the baseplate. Joining the housing 150 to the power substrate 120 or to the baseplate may for example be done by clipping, screwing, clamping or gluing.

The housing 150 may be provided after the first encapsulation material 140 has been provided. However, it is also possible that the housing 150 is provided prior to covering at least the selective portions of the power semiconductor die 110 and the electrical connector 130 with the first encapsulation.

As shown in Figure 6E, a second encapsulation material 160 is arranged on the first encapsulation material 140. The first and second encapsulation materials 140, 160 at least partially fill the interior volume 151 formed by the housing 150. Furthermore, the first encapsulation material 140 exhibits a higher thermostability than the second encapsulation material 160. This may mean that the first encapsulation material 140 is more resistant to irreversible changes in its chemical and/or physical structure at high temperatures than the second encapsulation material 160. The first encapsulation material 140 may for example exhibit less weight loss and/or less shrinkage at elevated temperatures than the second encapsulation material 160.

The second encapsulation material 160 may for example comprise or consist of a suitable organic material. The second encapsulation material 160 may for example comprise or consist of a potting material, a polymer, a silicone gel, epoxy resin, acrylate, etc. The first and second encapsulation materials 130, 160 may in particular be different materials or the first and second encapsulation materials 130, 160 may have different material compositions.

The second encapsulation material 160 may be a comparatively cheap material while the first encapsulation material 140 may be a comparatively expensive material. The second encapsulation material 160 may e.g. be deposited on parts of the power semiconductor module 600 which during operation do not heat up above a critical temperature, e.g. a critical temperature of about 150°C or 175°C or 200°C or more. The first encapsulation material 140 on the other hand may be deposited on those parts of the power semiconductor module 600 which during operation do heat up to a temperature above the critical temperature.

In the above-described manner, the amount of the comparatively expensive first encapsulation material 140 used in the power semiconductor module 600 may be reduced without impairing thermostability of the module. This may for example reduce the costs of the power semiconductor module 600.

The second encapsulation material 160 may for example completely cover the first encapsulation material 140 or the second encapsulation material 160 may only partially cover the first encapsulation material 140. The second encapsulation material 160 may be arranged directly on at least a portion of the first side 121 of the power substrate 120. The second encapsulation material 160 may be in direct contact with the housing 150. The first encapsulation material 140 may or may not be in direct contact with the housing 150, depending on the location of the selective portions of the power semiconductor die 110 and the electrical connector 130 which are covered with the first encapsulation material 140.

According to an example, arranging the second encapsulation material 160 on the first encapsulation material 140 comprises depositing, in particular dispensing, the second encapsulation material into the interior volume 151.

The first and second encapsulation materials 140, 160 may partially fill the interior volume 151 or the first and second encapsulation materials 140, 160 may completely fill the interior volume 151. A volume of the second encapsulation material 160 may for example be 1.5 times as large, twice as large, three times as large, four times as large, or even larger than a volume of the first encapsulation material 140.

As shown in Figure 6F, fabricating the power semiconductor module 600 may optionally comprise arranging a lid 170 on the housing 150, wherein the lid 170 may be configured to close off the interior volume 151.

According to an example, the power semiconductor module 600 may comprise further external contacts which are exposed from the lid 170. These further external contacts may for example be sensing contacts and/or control contacts. Furthermore, a board comprising one or more logic dies may be arranged over the lid 170, wherein the board is electrically coupled to the further external contacts. The one or more logic dies may be configured to control the one or more power semiconductor dies 110.

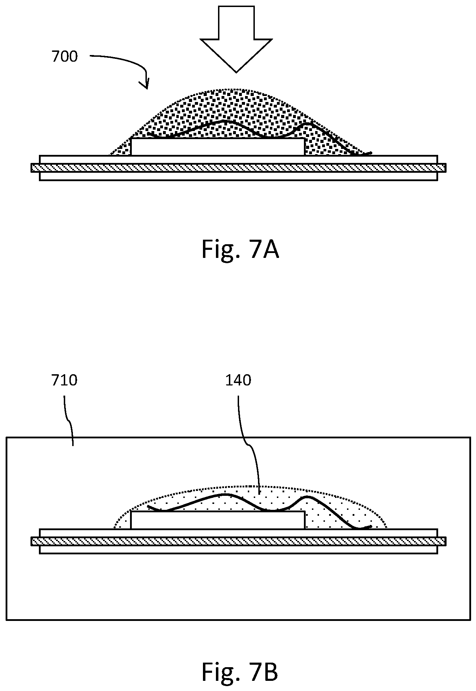

With respect to Figures 7A to 9, different methods of covering at least the selective portions of the power semiconductor die 110 and the electrical connector 130 of the power semiconductor module 600 with the first encapsulation material 140 are shown, according to specific examples.

As shown in Figure 7A, a liquid or powdery precursor 700 of the first encapsulation material 140 is dispensed over at least the selective portions of the power semiconductor die 110 and the electrical connector 130.

In the case that a liquid precursor 200 is used, the liquid precursor 700 may for example be a thixotropic material and/or a material with a relatively high viscosity. In this way, the precursor 700 does not dissolve from the parts of the power semiconductor module 100 it was dispensed over.

As shown in Figure 7B, the precursor 700 is cured in order to fabricate the first encapsulation material 140. Curing the precursor 700 may comprise applying heat and/or radiation to the precursor 700. For example, an oven 710 may be used to cure the precursor 700. Alternatively or additionally, a UV lamp, an IR lamp, a hot plate or any other suitable means for curing the precursor 700 may be used.

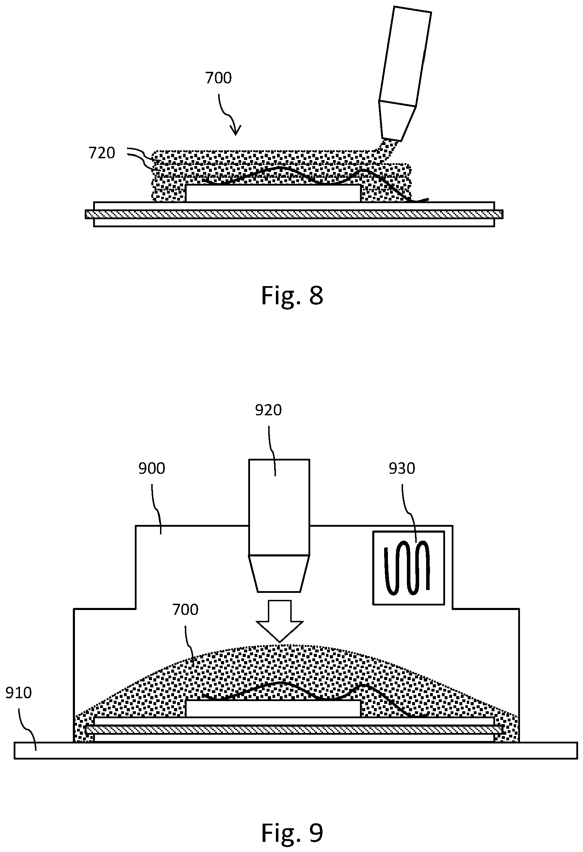

As shown in Figure 8, a liquid precursor 700 may be deposited by dispensing a plurality of lines 720 of the liquid precursor 700 on top of each other. This way of dispensing the liquid precursor 700 may be akin to a 3D printing process. The liquid precursor 700 may have a high viscosity such that it does not dissolve prior to curing.

According to an example, individual lines 720 of the precursor 700 are dispensed on top of each other. According to an example, the plurality of lines 720 is dispensed in a meandering shape or one or more contiguous lines are dispensed in a meandering shape.

As shown in Figure 9, at least the selective portions of the power semiconductor die 110 and at least the selective portions of the electrical connector 130 may be arranged inside a temporary frame 900.

The temporary frame 900 may be part of a dispensing equipment. The temporary frame 900 may be configured to act as a holder for holding a liquid or powdery precursor 700 until the precursor 700 has been cured. A bottom of the temporary frame 700 may for example be sealed by a temporary carrier 910, in particular a tape, wherein the power substrate 120 is arranged on the temporary carrier 910.

The liquid or powdery precursor 700 of the first encapsulation material 140 may be dispensed into the temporary frame 900 such that the precursor 700 is held in place by the temporary frame 900. In order to dispense the precursor 700, the temporary frame 900 may be equipped with an integrated dispenser 920. In this way, the temporary frame 900 and the dispenser 920 may be placed over the power semiconductor die 110 and the electrical connector 130 in one step. However, it is also possible that the dispensing tool is independent of the temporary frame 900.

As mentioned above, the precursor 700 is cured while the temporary frame 900 is in place. For this purpose, the temporary frame 900 may be equipped with integrated curing means 930 which may e.g. comprise a heater and/or a light source. Again, it is also possible that the curing means are independent of the temporary carrier 900. In addition or alternatively, a hardening agent may be added to the precursor 700 within the frame 900 to facilitate curing.

Once the precursor 700 has been cured (i.e. once the first encapsulation material 140 has been fabricated), the temporary frame 900 may be removed. According to an example, the temporary frame 900 consists of a plurality of parts which may be disassembled in order to remove the temporary frame 900 from the first encapsulation material 140. However, it is also possible that the temporary frame 900 is removed as one part.

Instead of the temporary frame 900 described with respect to Fig. 9, it is also possible to use the housing 150 to hold the precursor 700 in place for the curing process. In other words, the power semiconductor die 110 and the power substrate 120 may be enclosed with the housing 150 and afterwards the precursor 700 may be dispensed into the interior volume 151 and then cured. After the curing process, the housing 150 is not removed like the temporary frame 900 but remains as a part of the power semiconductor module 600.

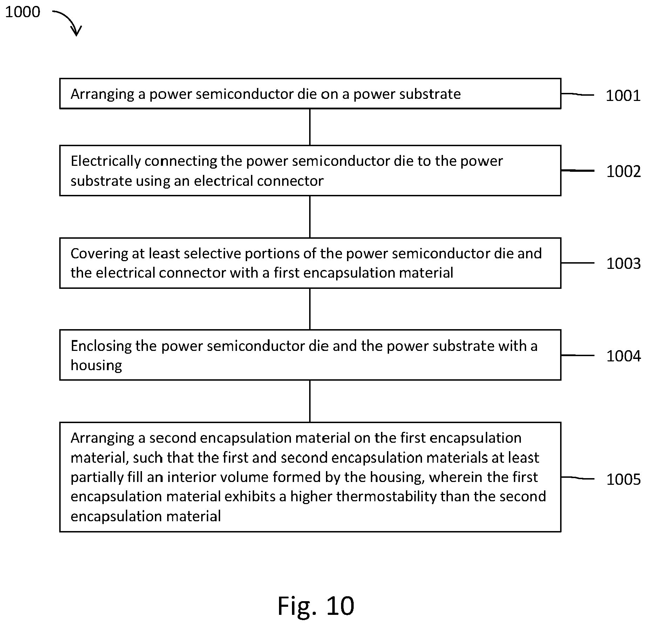

Figure 10 is a flow chart of a method 1000 for fabricating a power semiconductor module. The method 1000 may for example be used to fabricate the power semiconductor module 600. The method 1000 comprises at 1001 an act of arranging a power semiconductor die on a power substrate, at 1002 an act of electrically connecting the power semiconductor die to the power substrate using an electrical connector, at 1003 an act of covering at least selective portions of the power semiconductor die and the electrical connector with a first encapsulation material, at 1004 an act of enclosing the power semiconductor die and the power substrate with a housing, and at 1005 an act of arranging a second encapsulation material on the first encapsulation material, such that the first and second encapsulation materials at least partially fill an interior volume formed by the housing, wherein the first encapsulation material exhibits a higher thermostability than the second encapsulation material.

### EXAMPLES

In the following, the power semiconductor module and the method for fabricating a power semiconductor module are further explained using specific examples.

Example 1 is a power semiconductor module, comprising: a power semiconductor die arranged on a power substrate, a housing enclosing the power semiconductor die and the power substrate, wherein an interior volume formed by the housing is divided by interior walls into at least a first compartment and a second compartment, wherein the power semiconductor die is arranged within the first compartment, a first encapsulation material encapsulating the power semiconductor die and at least partially filling the first compartment, and a second encapsulation material different from the first encapsulation material, the second encapsulation material encapsulating the first encapsulation material and at least partially filling the second compartment, wherein the first encapsulation material is arranged within the first compartment but not within the second compartment.

Example 2 is the power semiconductor module of example 1, wherein the second encapsulation material encapsulates the first encapsulation material on all sides except for the side comprising the power substrate.

Example 3 is the power semiconductor module of example 1 or 2, wherein the first encapsulation material is a liquid.

Example 4 is the power semiconductor module of example 3, wherein the first encapsulation material is a liquid at temperatures between -40°C and 200°C.

Example 5 is the semiconductor module of example 3 or 4, wherein the first encapsulation material is a silicon-based oil.

Example 6 is the power semiconductor module of one of the preceding examples, wherein the second encapsulation material is or comprises a gel.

Example 7 is the power semiconductor module of one of the preceding examples, wherein the second encapsulation material is configured to maintain the first encapsulation material at a substantially constant pressure by elastically deforming in response to a thermal expansion or a thermal contraction of the first encapsulation material.

Example 8 is the power semiconductor module of one of the preceding examples, further comprising: an electrical connector connecting the power semiconductor die to the power substrate, wherein the electrical connector is arranged within the first compartment and encapsulated by the first encapsulation material.

Example 9 is the power semiconductor module of one of the preceding examples, further comprising: a three-dimensional grid structure that is substantially rigid at room temperature and is immersed within the first encapsulation material.

Example 10 is the power semiconductor module of one of the preceding examples, wherein the power semiconductor die is arranged on a first side of the power substrate, and wherein the second encapsulation material is coupled to the first side of the power substrate such that a water-tight seal for the first encapsulation material is provided.

Example 11 is the power semiconductor module of one of the preceding examples, wherein the first compartment comprises a part of the module with a comparatively higher operating temperature and the second compartment comprises a part of the module with a comparatively lower operating temperature.

Example 12 is a method for fabricating a power semiconductor module, the method comprising: arranging a power semiconductor die on a power substrate, enclosing the power semiconductor die and the power substrate with a housing, wherein an interior volume formed by the housing is divided by interior walls into at least a first compartment and a second compartment, wherein the power semiconductor die is arranged within the first compartment, encapsulating the power semiconductor die with a first encapsulation material such that the first encapsulation material at least partially fills the first compartment, and encapsulating the first encapsulation material with a second encapsulation material different from the first encapsulation material, such that the second encapsulation material at least partially fills the second compartment, wherein the first encapsulation material is arranged within the first compartment but not within the second compartment.

Example 13 is the method of example 12, wherein the second encapsulation material encapsulates the first encapsulation material on all sides except for the side comprising the power substrate.

Example 14 is the method of example 12 or 13, wherein the first encapsulation material is a liquid.

Example 15 is the method of one of examples 12 to 14, wherein encapsulating the first encapsulation material comprises providing a water-tight seal between the second encapsulation material and a first side of the power substrate.

Example 16 is an apparatus comprising means for performing the method according to anyone of claims 12 to 15.

While the disclosure has been illustrated and described with respect to one or more implementations, alterations and/or modifications may be made to the illustrated examples without departing from the spirit and scope of the appended claims. In particular regard to the various functions performed by the above described components or structures (assemblies, devices, circuits, systems, etc.), the terms (including a reference to a "means") used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the disclosure.

## Claims

1. A power semiconductor module (100), comprising:
a power semiconductor die (110) arranged on a power substrate (120),
a housing (150) enclosing the power semiconductor die (110) and the power substrate (120), wherein an interior volume (151) formed by the housing (150) is divided by interior walls (152) into at least a first compartment (151') and a second compartment (151''), wherein the power semiconductor die (110) is arranged within the first compartment (151'),
a first encapsulation material (140) encapsulating the power semiconductor die (110) and at least partially filling the first compartment (151'), and
a second encapsulation material (160) different from the first encapsulation material (140), the second encapsulation material (160) encapsulating the first encapsulation material (140) and at least partially filling the second compartment (151''),
wherein the first encapsulation material (140) is arranged within the first compartment (151') but not within the second compartment (151'').

2. The power semiconductor module (100) of claim 1, wherein the second encapsulation material (160) encapsulates the first encapsulation material (140) on all sides except for the side comprising the power substrate (120).

3. The power semiconductor module (100) of claim 1 or 2, wherein the first encapsulation material (140) is a liquid.

4. The power semiconductor module (100) of claim 3, wherein the first encapsulation material (140) is a liquid at temperatures between -40°C and 200°C.

5. The semiconductor module (100) of claim 3 or 4, wherein the first encapsulation material (140) is a silicon-based oil.

6. The power semiconductor module (100) of one of the preceding claims, wherein the second encapsulation material (160) is or comprises a gel.

7. The power semiconductor module (100) of one of the preceding claims, wherein the second encapsulation material (160) is configured to maintain the first encapsulation material (140) at a substantially constant pressure by elastically deforming in response to a thermal expansion or a thermal contraction of the first encapsulation material (140).

8. The power semiconductor module (300) of one of the preceding claims, further comprising:
an electrical connector (310) connecting the power semiconductor die (110) to the power substrate (120),
wherein the electrical connector (310) is arranged within the first compartment (151') and encapsulated by the first encapsulation material (140).

9. The power semiconductor module (400) of one of the preceding claims, further comprising:
a three-dimensional grid structure (410) that is substantially rigid at room temperature and is immersed within the first encapsulation material (140).

10. The power semiconductor module (100) of one of the preceding claims, wherein the power semiconductor die (110) is arranged on a first side (121) of the power substrate (120), and
wherein the second encapsulation material (160) is coupled to the first side (121) of the power substrate (120) such that a water-tight seal for the first encapsulation material (140) is provided.

11. The power semiconductor module (100) of one of the preceding claims, wherein the first compartment (151') comprises a part of the module (500) with a comparatively higher operating temperature and the second compartment (151'') comprises a part of the module (500) with a comparatively lower operating temperature.

12. A method (500) for fabricating a power semiconductor module, the method (500) comprising:
arranging (501) a power semiconductor die on a power substrate,
enclosing (502) the power semiconductor die and the power substrate with a housing, wherein an interior volume formed by the housing is divided by interior walls into at least a first compartment and a second compartment, wherein the power semiconductor die is arranged within the first compartment,
encapsulating (503) the power semiconductor die with a first encapsulation material such that the first encapsulation material at least partially fills the first compartment, and
encapsulating (504) the first encapsulation material with a second encapsulation material different from the first encapsulation material, such that the second encapsulation material at least partially fills the second compartment,
wherein the first encapsulation material is arranged within the first compartment but not within the second compartment.

13. The method (500) of claim 12, wherein the second encapsulation material encapsulates the first encapsulation material on all sides except for the side comprising the power substrate.

14. The method (500) of claim 12 or 13, wherein the first encapsulation material is a liquid.

15. The method (500) of one of claims 12 to 14, wherein encapsulating (504) the first encapsulation material comprises providing a water-tight seal between the second encapsulation material and a first side of the power substrate.
